# EUROPEAN PATENT APPLICATION

(11) **EP 1 670 298 A1**
(43) Date of publication of application: **14.06.2006**
(21) Application number: 04078333.4
(22) Date of filing: 07.12.2004
(51) Int. Cl.: H05K 3/12, H01L 51/40

(54) **Substrate for a display and method for manufacturing the same**

(71) Applicant: Samsung SDI Germany GmbH, 12459 Berlin (DE); Samsung SDI Co., Ltd., Suwon-si, Gyeonggi-do (KR)
(72) Inventor: Klyszcz, Andreas, 14050 Berlin (DE); Schaedig, Marcus, 15711 Königs Wusterhausen (DE); Humbs, Werner, 12555 Berlin (DE)
(74) Representative: Hengelhaupt, Jürgen

(57) **Abstract**

This invention relates to a substrate for a display having a plurality of ink jet printed conductive lines (4) and a method for manufacturing the same. More specifically, this invention relates substrate for a PDP having plurality of ink jet printed conductive lines (4) for address and bus electrodes.

One object of the invention is to improve the adhesion of ink jet printed conductive lines (4), i.e. ink jet printed address and bus electrodes on a ground substrate (1). Another object of the invention is to improve the contact angle of ink jet printed conductive lines (4) in order to enable a high resolution display on said ground substrate (1).

The present invention is directed to method for manufacturing a substrate for a display having a plurality of conductive lines (4) comprising the steps of:
- application of a metal adhesion promoter layer (7) on a ground substrate (1),
- application of a layer (6) of fluorinated precursors and
- application of a plurality of conductive lines (4).

## Description

### FIELD OF THE INVENTION

This invention relates to a substrate for a display having a plurality of ink jet printed conductive lines and a method for manufacturing the same. More specifically, this invention relates to a substrate for a PDP having a plurality of ink jet printed conductive lines for address and bus electrodes.

### BACKGROUND OF THE INVENTION

Ink jet printed bus and address electrodes in PDPs are printed using nano-particle ink. Silver nano-particle ink is composed of individually dispersed metal nano-particles, surfactants and organic particles (EP1349135A1, US20040043691A1, ULVAC).

US20040038616A1 (Fujitsu) describes a method of manufacturing a substrate for a flat panel display, the method comprising: forming a plurality of grooves in the bottom of a float glass substrate by a subtractive process to form barrier ribs comprising protrusions remaining between the respective grooves, and then forming electrodes on the bottoms of the grooves by an ink-jet process or a dispensing process. An alternative process to form narrow metal lines on glass or ITO surfaces using the nano-particle ink is to treat the substrate moderately and to have a contact angle of 60° for the nano-particle ink (US20030083203A, Seiko Epson; M. Furusawa et al, SID 02 Digest, 753 - 755). In conventional surface treatment methods, like fluorination with CF₄, C₂F₆, C₃F₈ or fluoroalkyl-functionalized silanes contact angles of 20° to 60° can be achieved, but the drawback is a loss in adhesion for the printed and cured metal lines.

The Korean patent Nr. 0229232 (Canon) describes a droplet deposition on a hydrophobised substrate. The hydrophobisation was realized by silane compounds like HMDS, PHAMS, AMP or PES and found its application by PDPs (Plasma Display Panels).

Furthermore it is noted by the Korean patent Nr. 2003-0084608 (Seiko Epson Corp) that a fluid containing metal particles was deposited and controlled on the surface of a substrate. An intermediate film of fluid material improved the electrical contact. Here fluoroalkylated silanes are used to form a self-assembled monolayer (SAM).
An invention describes the manufacturing of FEDs. A pair of electrodes get contacted with a conductive thin film on a substrate. This film was realized by the "droplet-method" using a metal based fluid (Korea reg. Patent 0229232; Canon KK).
By releasing a fluid onto a substrate, which contains metal particles, a conductive, structured thin film is formed. The release of an intermediate fluid leads to an intermediate thin film on the substrate, which improves the adhesion between the substrate and the conductive film (Korean Patent 2003-0084608; SEIKO EPSON).

An organic fluid is used to yield a thin film patterned layer (Patent US 6677238; Seiko Epson).

### OBJECTS OF THE INVENTION

Therefore one object of the invention is to improve the adhesion of ink jet printed conductive lines, i.e. ink jet printed address and bus electrodes on a ground substrate. Another object of the invention is to improve the contact angle of ink jet printed conductive lines in order to enable a high resolution display on said ground substrate.

### SUMMARY OF THE INVENTION

The present invention is directed to a method for manufacturing a substrate for a display having a plurality of conductive lines comprising the steps of:
- application of a metal adhesion promoter layer on a ground substrate,
- application of a layer of fluorinated precursors and
- application of a plurality of conductive lines.

In order to improve adhesion and contact angle of ink jet printed conductive lines on a ground substrate the invention proposes to introduce at least one intermediate layer between ground substrate and conductive lines. The metal adhesion promoter layer and the layer of fluorinated precursors can be applied one after another resulting in two intermediate layers. Alternatively it is possible to apply the metal adhesion promoter layer and the layer of fluorinated precursors at the same time resulting in one layer comprising both, metal adhesion promoter silanes and the fluorinated precursors. Such a layer can be manufactured by self-assembly of metal adhesion promoter silanes in the presence of fluorinated precursors.

Preferably fluorinated organic molecules having functional groups comprising at least amine, diamine, triamine, tetraamine, polyamine, pyridine, imidazole, carboxylic acid, sulfonic acid, phosphate, phosphonate and/or phenol are used as fluorinated precursors. Preferably the fluorinated precursors are applied by a wet chemistry process.

The metal adhesion promoter layer is preferably applied by
a) a plasma treatment of NH₃, H₂S and/or PH₃ or
b) a plasma treatment of a substance of the formula (I)

   YRₙ n = 2,3 (I)

   wherein Y is a N-, S- or a P-atom and R is a H-atom and/or at least one alkylgroup or
c) plasma polymerisation of a silane with the formula (II)

   Z R'ₘ m = 2,3 (II)
wherein Z is a N-, S- or a P-atom and R' is a H-atom and/or at least one silane group with the formula (III)

   Si R"₃ (III)

   wherein R" is an alkylgroup, which may be identical or different or
d) a wet chemical process with a substance of the formula (IV)

   R"' Si X₄ (IV)

   wherein R'" is a H-atom, an OH-group, a Cl-atom and/or an alkoxy group and X are each independently a H-atom, an OH-group, a Cl-atom, an alkoxy group, an alkyl group and/or organic group, wherein the organic group comprises at least one metal binding group. Preferably an organic group comprising at least amine, diamine, triamine, tetraamine, polyamine, amide, polyamide, hydrazine, pyridine, imidazole, thiophene, carboxylic acid, carboxylic acid halogenide, sulfide, disulfide, trisulfide, tetrasulfide, polysulfide, sulfonic acid, sulfonic acid halogenide, phosphate, phosphonate, epoxide, phenol and/or polyether is used as the organic group.

The plasma polymerisation is preferably a polymerisation of Hexamethyldisilazane.

In cases of two intermediate layers (metal adhesion promoter layer and layer of fluorinated precursors) it is proposed by the present invention that the metal adhesion promoter layer is applied at first and the layer of fluorinated precursors thereafter.

The described methods result in intermediate layer(s) which leads to ink jet printed conductive lines showing an improvement of both, contact angle for the ink droplet on the substrate, which is important for final resolution and an improved adhesion of the cured conductive, i.e. metal lines. Therefore, the adhesion of ink jet printed address and bus electrodes on the ground substrate is much higher and fulfills process requirements in PDP manufacturing.

Preferably the metal adhesion promoter layer and the layer of fluorinated precursors are applied as a monolayer or a dilayer and/or with a thickness of 1 nm to 10 nm. In case the metal adhesion promoter layer and the layer of fluorinated precursors are formed as one intermediate layer comprising molecules of the formula (IV) or molecules of the fomulare (III) (for example hexamethyldisilazane) and organic molecules having functional groups comprising at least amine, diamine, triamine, tetraamine, polyamine, pyridine, imidazole, carboxylic acid, sulfonic acid, phosphate, phosphonate and/or phenol which are crosslinked and disposed side by side this (intermediate) layer may comprise a thickness of 1 nm to 10 nm.

The ground substrate may be a flat and/or flexible glass substrate, an indium tin oxide (ITO) coated glass substrate or a polymer substrate. The plurality of conductive lines is preferably applied by ink jet printing. The ink may consist of a liquid solution of a dispersed metal nano powder and a solvent. The metal may be silver, gold, platinum, palladium or copper. The ink may comprise an additive which consists of metal stabilizing organic polymers.

The substrate according to the present invention comprises a ground substrate with a plurality of conductive lines whereby a metal adhesion promoter layer and a layer of fluorinated precursors are disposed between said ground substrate and said conductive lines. The conductive lines may comprise metal nano powder where the metal size is 1 nm to 100 nm. The metal adhesion promoter layer may comprise crosslinked molecules of the formula (III) or crosslinked silanes with the formula (IV) (e.g. Hexamethyldisilazane). The layer of fluorinated precursors may comprise crosslinked fluorinated organic molecules.

The metal adhesion promoter layer and the layer of fluorinated precursors may be disposed on top of each other or the metal adhesion promoter layer and the layer of fluorinated precursors are formed by one layer comprising crosslinked molecules of the formula (III) or crosslinked silanes with the formula (I) (e.g. Hexamethyldisilazane) and crosslinked organic molecules. In this case the molecules (of formula (III) or silanes with the formula (VI) (e.g. Hexamethyldisilazane) and the organic molecules) are disposed side by side.

### BRIEF DESCRIPTION OF THE DRAWINGS

The present invention will now be described by way of example with reference to the accompanying drawings, in which:

Fig. 1 and Fig. 2 show a sectional view of the essential method steps for the manufacture of a substrate for a display according to embodiments of the present invention in which the metal adhesion promoter layer and the layer of fluorinated precursors are disposed one upon the other, and

Fig. 3 shows a sectional view of the essential method steps for the manufacture of a substrate for a display according to an embodiment of the present invention in which the metal adhesion promoter layer and the layer of fluorinated precursors are applied at the same time.

### DETAILED DESCRIPTION OF PREFERRED EMBODIMENTS

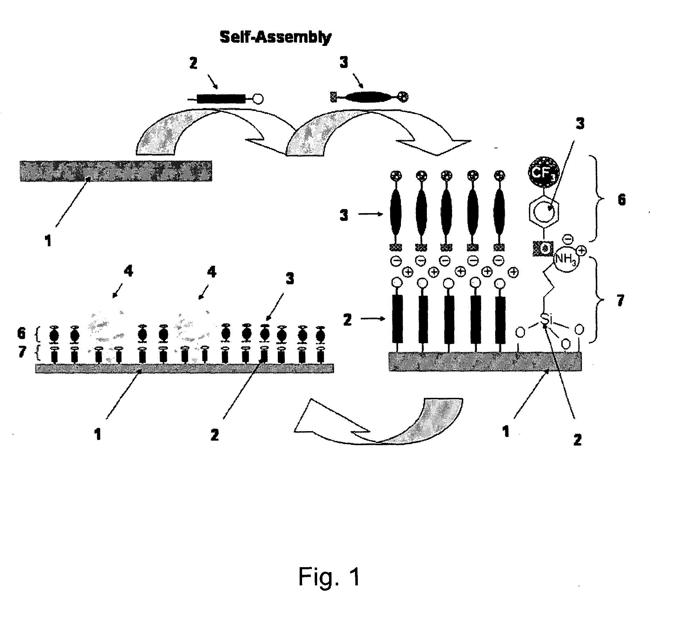

A typical manufacturing process of an adhesion promoting and line width positioning intermediate layer according to the present invention will now be described with reference to Figure 1.

An ITO coated glass ground substrate 1 undergoes a two step self-assembly process. At the first step the substrate is dipped for 10-90 seconds into a 10⁻¹-10⁻⁵ mol/l solution of a metal adhesion promoter silane 2 (3-aminopropyl)triethoxysilane, dried at 50-200 °C for 1-60 minutes and cooled down to room temperature. Thereby the layer 7 of metal adhesion promoter silanes is obtained. At the second step the substrate is dipped for 10-90 seconds into a 10⁻¹-10⁻⁵ mol/l solution of a fluorinated precursor 3 (4-hydroxybenzotrifluoride) and dried at 50-200 °C for 1-60 minutes. Thereby the layer 6 of fluorinated precursors is obtained. By reducing the surface energy with fluorinated precursors 3 the final resolution of ink jet printed conductive address and bus electrodes (i.e. conductive lines 4) can be controlled. This surface treatment also enables to crosslink ink jet printed metal nano-particles 4 (silver nano-particles) to specific metal adhesion promoting functional groups like an amino group. The fluorinated precursors 3 reduce the surface energy in order to ensure a specific line resolution. Finally, silver nano ink comprising silver nano particles 4 will be ink jet printed using a multinozzle ink jet printer. After drying the ink the printed substrate will be heat treated at 250°C for 20 min, so that the ink jet printed lines 4 are getting conductive.

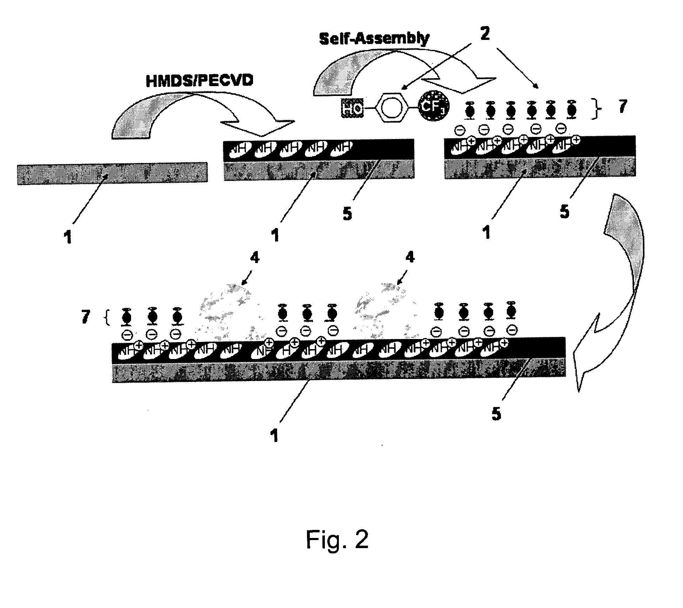

A similar manufacturing process of an adhesion promoting and line width positioning intermediate layer according to the present invention will now be described with reference to Figure 2. Instead of a metal adhesion promoter silane 2 a polymerised HMDS (Hexamethyldisilazane) is applied by plasma enhanced chemical vapour deposition (PECVD) as a metal adhesion promoter which results in the layer 5 of polymerised Hexamethyldisilazane.

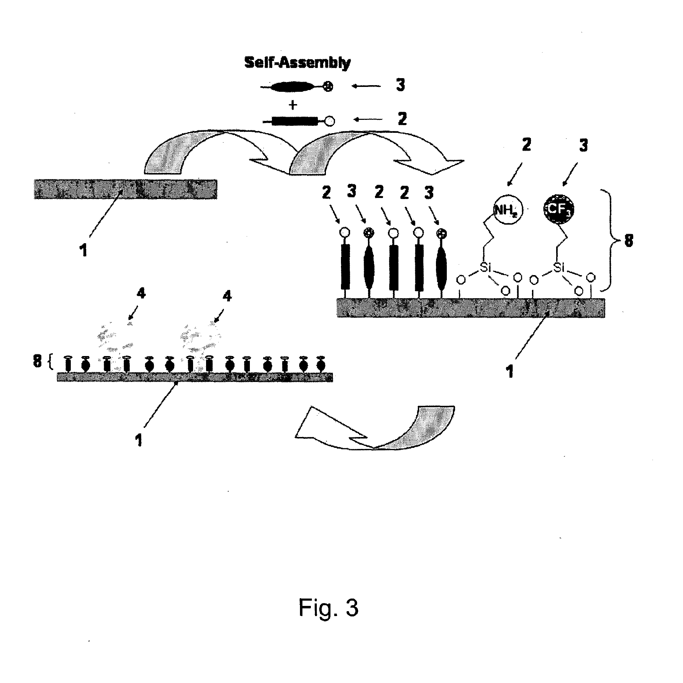

Beside the two step self-assembly process (according Fig. 1 and Fig. 2) of metal adhesion promoter silanes and fluorinated precursor or the two step HMDS/fluorinated precursor treatment the intermediate layer can also be introduced by a self-assembly process of metal adhesion promoter silanes 2 in the presence of fluorinated precursors 3 (see Fig. 3). Thereby the layer 8 of metal adhesion promoter silanes and fluorinated precursors is obtained. A mixed self-assembled monolayer (MSAM) realises the final resolution of the ink jet printed address and bus electrodes (i.e. lines 4) by tailoring the surface energy of the substrate and ensuring an improved adhesion at the same time.

In principle, the presence of a crosslinked macromolecular structure, based on Si-C-Si, Si-N, Si-N-C, and C-N-C linkages (like in the case of HMDS) or metal adhesion promoting organic functional groups based on C-N, C-O, C-S, C-P, Si-N, Si-O, Si-S and Si-P can be detected by ESCA (Electron Spectroscopy for Chemical Analysis) and ATR-FTIR (Attenuated Total Reflectance Fourier Transform Infrared Spectroscopy).

Finally, on the layer 8 silver nano ink comprising silver nano particles 4 will be ink jet printed using a multinozzle ink jet printer. After drying of the ink the printed substrate will be heat treated at 150° - 250°C for 20 min, so that the ink jet printed lines 4 are getting conductive. The substrate (upper and lower side) can now be used for further process steps for PDP (Plasma Display Panel) manufacture.

While this invention has been described in conjunction with specific embodiments thereof, it is evident that many alternatives, modifications and variations will be apparent to those skilled in the art. Accordingly, the preferred embodiments of the invention as set forth herein are intended to be illustrative, not limiting. Various changes may be made without departing from the spirit of the invention as defined in the following claims.

### List of Reference Signs

- 1: Ground Substrate
- 2: Metal Adhesion Promoter Silane
- 3: Fluorinated Precursor
- 4: Conductive Line/ Nano Particle
- 5: Layer of polymerised Hexamethyldisilazane
- 6: Layer of Fluorinated Precursor
- 7: Layer of Metal Adhesion Promoter Silanes
- 8: Layer of Metal Adhesion Promoter Silanes and Fluorinated Precursor

## Claims

1. Method for the manufacture of a substrate for a display having a plurality of conductive lines (4) comprising the steps of:
- application of a metal adhesion promoter layer (5, 7) on a ground substrate (1),
- application of a layer (6) of fluorinated precursors and
- application of a plurality of conductive lines (4).

2. Method according to Claim 1, **wherein**
the metal adhesion promoter layer (5, 7) is applied by:
a plasma treatment of NH₃, H₂S and/or PH₃
or
a plasma treatment of a substance of the formula (I)
YRₙ n = 2,3 (I)
wherein Y is a N-, S- or a P-atom and R is a H-atom and/or at least one alkylgroup
or
a plasma polymerisation of a silane with the formula (II)
ZR'ₘ m = 2,3 (II)
wherein Z is a N-, S- or a P-atom and R' is a H-atom and/or at least one silane group with the formula (III)
Si R"₃ (III)
wherein R" is an alkylgroup, which may be identical or different.

3. Method according to Claim 1,**wherein**
a substance of the formula (IV)
R Si X₄ (IV)
is used for the application of the metal adhesion promoter layer (5, 7), wherein R is a H-atom, an OH-group, a Cl-atom and/or an alkoxy group and X are each independently a H-atom, an OH-group, a Cl-atom, an alkoxy group, an alkyl group and/or organic group, wherein the organic group comprises at least one metal binding group.

4. Method according to Claim 3, **wherein**
an organic group comprising at least amine, diamine, triamine, tetraamine, polyamine, amide, polyamide, hydrazine, pyridine, imidazole, thiophene, carboxylic acid, carboxylic acid halogenide, sulfide, disulfide, trisulfide, tetrasulfide, polysulfide, sulfonic acid, sulfonic acid halogenide, phosphate, phosphonate, epoxide, phenol and/or polyether is used as the organic group.

5. Method according to Claim 3 or 4, **wherein**
metal adhesion promoter layer (5, 7) is applied by a wet chemistry process.

6. Method according to Claim 5, **wherein**
the metal adhesion promoter layer (5, 7) is applied by dipping the ground substrate (1) into a solution of a substance of the formula (I).

7. Method according to Claim 1, **wherein**
fluorinated organic molecules are used for the application of the layer (6) of fluorinated precursors.

8. Method according to Claim 7, **wherein**
fluorinated organic molecules having functional groups comprising at least amine, diamine, triamine, tetraamine, polyamine, pyridine, imidazole, carboxylic acid, sulfonic acid, phosphate, phosphonate and/or phenol are used as fluorinated organic molecules.

9. Method according to Claim 7 or 8, **wherein**
the layer (6) of fluorinated precursors is applied by a wet chemistry process.

10. Method according to Claim 7 or 9, **wherein**
the layer (6) of fluorinated precursors is applied by dipping the ground substrate (1) into a solution of fluorinated organic molecules having functional groups comprising at least amine, diamine, triamine, tetraamine, polyamine, pyridine, imidazole, carboxylic acid, sulfonic acid, phosphate, phosphonate and/or phenol.

11. Method according to Claim 5 or 11, **wherein**
the solution comprises a concentration of 10⁻¹ - 10⁻⁵ mol/l.

12. Method according to Claim 1, **wherein**
the application of the metal adhesion promoter layer (5, 7) and the layer (6) of fluorinated precursors is carried out at the same time.

13. Method according to Claim 12, **wherein**
the application of the metal adhesion promoter layer (5, 7) and the layer (6) of fluorinated precursors is carried out by dipping the ground substrate (1) into a solution, wherein the solution comprises both
a substance of the formula (IV) and
fluorinated organic molecules having functional groups comprising at least amine, diamine, triamine, tetraamine, polyamine, pyridine, imidazole, carboxylic acid, sulfonic acid, phosphate, phosphonate and/or phenol.

14. Method according to Claims 1 to 13, **wherein**
the metal adhesion promoter layer (5, 7) and the layer (6) of fluorinated precursors are applied as a monolayer or a dilayer and/or with a thickness of 1 nm to 10 nm.

15. Method according to Claims 1 to 14, **wherein**
a flat and/or flexible glass substrate, an Indium tin oxide coated glass substrate or a polymer substrate is used as a ground substrate (1).

16. Method according to Claims 1 to 14, **wherein**
the plurality of conductive lines (4) is applied by ink jet printing.

17. Method according to Claim 16, **wherein**
an ink is used where the ink consists of a liquid solution of a dispersed metal nano powder and/or dispersed metal nanocomposite and a solvent.

18. Method according to Claim 17, **wherein**
the metal is silver, gold, platinum, palladium or copper.

19. Method according to Claim 17, **wherein**
the ink comprises an additive wherein the additive consists of metal stabilizing organic polymers.

20. Substrate for a display with a ground substrate (1) having a plurality of conductive lines (4)
**characterised in that**
a metal adhesion promoter layer (5, 7) and a layer (6) of fluorinated precursors are disposed between said ground substrate (1) and conductive lines (4).

21. Substrate according to Claim 20, **wherein**
conductive lines (4) comprise sintered metal nano powder where the metal nano particle size is 1 nm to 100 nm.

22. Substrate according to Claim 20, **wherein**
the metal adhesion promoter layer (5, 7) comprises crosslinked molecules of the formula (I), crosslinked molecules of the formula (II) or crosslinked molecules the formula (IV).

23. Substrate according to Claim 20, **wherein**
the layer (6) of fluorinated precursors comprises crosslinked fluorinated organic molecules having functional groups comprising at least amine, diamine, triamine, tetraamine, polyamine, pyridine, imidazole, carboxylic acid, sulfonic acid, phosphate, phosphonate and/or phenol.

24. Substrate according to Claims 20 to 23, **wherein**
the metal adhesion promoter layer (5, 7) and the layer (6) of fluorinated precursors are disposed on top of each other.

25. Substrate according to Claim 20, **wherein**
the metal adhesion promoter layer (5, 7) and the layer (6) of fluorinated precursors are formed by one layer (8) comprising:
molecules of the formula (I), formula (II) or formula (VI)
and
fluorinated organic molecules having functional groups comprising at least amine, diamine, triamine, tetraamine, polyamine, pyridine, imidazole, carboxylic acid, sulfonic acid, phosphate, phosphonate and/or phenol which are crosslinked and disposed side by side.
